# EUROPEAN PATENT APPLICATION

(11) **EP 1 717 918 A1**
(43) Date of publication of application: **02.11.2006**
(21) Application number: 05710105.7
(22) Date of filing: 10.02.2005
(51) Int. Cl.: H01S 5/227, H01S 5/062, H01S 5/12

(54) **VARIABLE-WAVELENGTH SEMICONDUCTOR LASER AND GAS SENSOR USING SAME**

(30) Priority: 16.02.2004 JP 2004037801
(71) Applicant: ANRITSU CORPORATION, Atsugi-shi, Kanagawa 243-8555 (JP)
(72) Inventor: MORI, Hiroshi, Atsugi-shi, Kanagawa 243-8555 (JP); KIKUGAWA, Tomoyuki, Atsugi-shi, Kanagawa 243-8555 (JP); TAKAHASHI, Yoshio, Atsugi-shi, Kanagawa 243-8555 (JP); SUZUKI, Toshiyuki, Atsugi-shi, Kanagawa 243-8555 (JP); KIMURA, Kiyoshi, Atsugi-shi, Kanagawa 243-8555 (JP)
(74) Representative: Pautex Schneider, Nicole Véronique
(86) International application number: PCT/JP2005/002053
(87) International publication number: WO 2005/078880

(57) **Abstract**

A tunable wavelength semiconductor laser includes an n-type semiconductor substrate, an active layer which is disposed above the n-type semiconductor substrate and which generates light, a p-type cladding layer disposed above the active layer, and wavelength selecting section for causing to selectively oscillate only a specific wavelength from the light generated in the active layer. The tunable wavelength semiconductor layer capable of oscillating at the specific wavelength can be performed by injecting current into the active layer, and the specific wavelength can be varied by changing the magnitude of the current. A device length showing a length in a propagation direction of the light generated in the active layer is about 200 µm to 500 µm, and a width of the active layer orthogonal to the propagation direction of the light generated in the active layer, and showing a length in a direction parallel to the n-type semiconductor substrate is about 1 µm to 2 µm. The p-type cladding layer includes a lightly doped cladding layer having a low impurity concentration and a heavily doped cladding layer having a high impurity concentration which are sequentially arranged from the active layer side.

## Description

### Technical Field

The present invention relates to a tunable wavelength semiconductor laser and a gas detector using the same, and more particularly to a tunable wavelength semiconductor laser in which a wavelength of exit laser light is tunable, and a gas detector having the tunable wavelength semiconductor laser incorporated therein.

### Background Art

Gases such as methane, carbon dioxide, acetylene and ammonia are known to absorb light of a specific wavelength depending on rotation of a molecule or vibration of constituent atoms.

For example, methane absorbs light of wavelength (absorption wavelength) of 1.6 µm, 3.3 µm, and 7 µm.

Therefore, by irradiating a space to be measured with laser light having the absorption wavelength, and measuring its state of attenuation, presence of the specific gas in the space to be measured and its gas concentration can be detected.

A gas detector making use of such a light absorption characteristic is disclosed in, for example, Patent document 1.

Patent document 1: Jpn. Pat. Appln. KOKAI Publication No. 11-326199, that is, in the gas detector, laser light emitted from a semiconductor laser module having a semiconductor laser incorporated therein passes through a gas to be measured composed of, for example, methane, and is made to be incident on a photoreceiver.

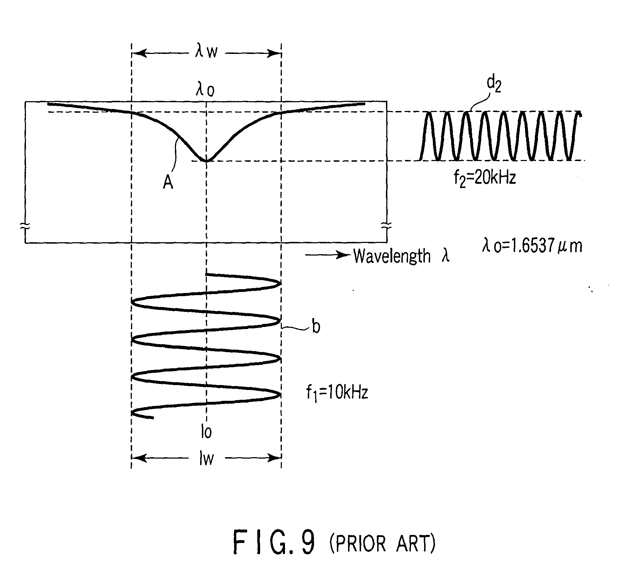

Herein, the gas to be measured composed of methane has, for example, an absorption characteristic A with an absorption central wavelength λ₀ = 1.6537 µm shown in FIG. 9.

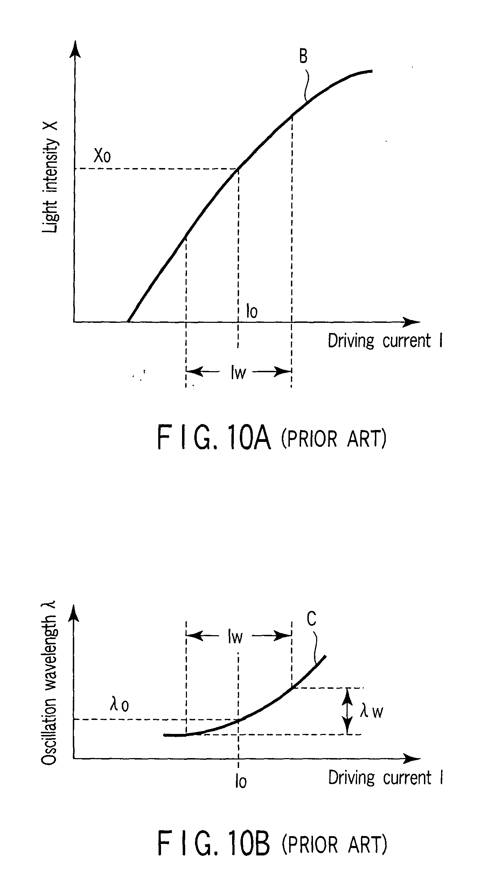

The semiconductor laser incorporated in the semiconductor laser module is a tunable wavelength semiconductor laser varying in oscillation wavelength λ depending on an applied driving current I as shown in a wavelength characteristic C in FIG. 10B.

In the tunable wavelength semiconductor laser, of course, the oscillation wavelength λ changes, and also light intensity X of exit laser light "a" varies depending on the applied driving current I as shown in an intensity characteristic B in FIG. 10A.

A laser drive control unit operates as shown in FIG. 9, in which a central current value I₀ (bias current value) is a value corresponding to the central wavelength λ₀ of the oscillation wavelength λ of the semiconductor laser, and applies a modulation signal b with an amplitude I_{W} and a modulation frequency f₁ = 10 kHz, around the central current value λ₀ (bias current value), to the semiconductor laser incorporated in the semiconductor laser module.

As a result, the semiconductor laser module emits laser light whose wavelength λ varies at the amplitude λ_{W} and at the frequency f₁ = 10 kHz around the absorption central wavelength λ₀.

The laser light thus modulated in wavelength around the absorption central wavelength λ₀ is absorbed depending on the absorption characteristic A in the process of passing through the gas to be measured, is received by the photo receiver, and is converted into an electrical signal to be input into a gas detection unit.

Since the photoreceiver does not have wavelength resolving capability of laser light, the electrical signal has a frequency component in the order of modulation frequency.

The gas detection unit extracts a fundamental wave signal d₁ as a signal component of modulation frequency f₁ = 10 kHz contained in the input electrical signal, and a double wave signal d₂ as a signal component of frequency f₂ (= 20 kHz) which is double the modulation frequency f₁ = 10 kHz contained in the input electrical signal, and whereby calculates a ratio (D₂/D₁) between an amplitude D₂ of the double wave signal d₂ and an amplitude D₁ of the fundamental wave signal d₁ and obtains a detection value D (= D₂/D₁) corresponding to the gas concentration.

Since a large offset due to intensity modulation occurs in the fundamental wave signal d₁ as shown in FIG. 10A, the ratio (D₂/D₁) between the amplitude D₂ of the double wave signal d₂ and the amplitude D₁ of the fundamental wave signal d₁ is calculated as the detection value D (= D₂/D₁) corresponding to the gas concentration, so that the precision of measurement is enhanced.

Such a conventional gas detector, however, has other problems to be solved.

That is, the gas detector is often used in detection of gas leak in actual gas piping fields, periodic inspection after piping installations, or detection for abnormality in chemical plants.

In this type of gas detector, therefore, it is desired to be smaller in size, higher in performance, and smaller in power consumption.

To realize a gas detector of smaller size, higher performance, and smaller power consumption, it is required that a semiconductor laser module 1 efficiently emits laser light whose wavelength λ varies at the amplitude λ_{W} and at the frequency f₁ = 10 kHz around the absorption central wavelength λ₀, corresponding to the absorption characteristic A shown in FIG. 9 of a gas 3 to be measured.

In the conventional semiconductor laser incorporated in the semiconductor laser module, however, as indicated by the intensity characteristic B in FIG. 10A and the wavelength characteristic C in FIG. 10B, it is necessary to set to a large value the bias current value (current value I₀) of the modulation signal b to be applied to the semiconductor laser in order to obtain the necessary central wavelength λ₀ and light intensity X₀, and hence the power consumption is increased.

In the wavelength characteristic C shown in FIG. 10B, the degree of change of oscillation wavelength (frequency) when the driving current I is changed in unit current is called frequency modulation efficiency η. In the conventional semiconductor laser, the frequency modulation efficiency η is very low, for example, less than 0.1 GHz/mA.

Therefore, to change the wavelength λ at the amplitude λ_{W} around the absorption central wavelength λ₀, a current amplitude I_{W} of the modulation signal b to be applied to the semiconductor laser is increased, and thus, the power consumption also increases.

Further, in the intensity characteristic B in FIG. 10A, the light intensity X of the laser light "a" emitted from the semiconductor laser is not completely proportional to the current value I of the modulation signal b applied to the semiconductor laser, but tends to be saturated near the upper limit of the current amplitude I_{W}.

Thus, as the nonlinear state of the intensity characteristic B increases, modulation distortion of the laser light becomes larger, and a detection value D (= D₂/D₁) calculated from the detected electrical signal does not correspond correctly to the gas concentration, and the precision of measurement is lowered.

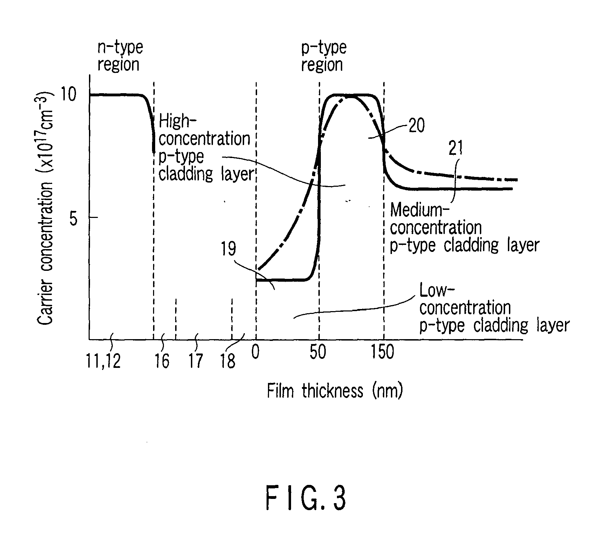

The present inventors or the like have proposed, in a semiconductor laser disposed in Patent document 2, a semiconductor laser capable of obtaining high luminescent efficiency and high output, characterized by an impurity concentration distribution having Zn in a p-type cladding layer as a p-type impurity, substantially same as in FIG. 3 to which the invention as described later is applied.

Patent document 2: USP 6,351,479.

Although a semiconductor laser capable of obtaining high luminescent efficiency and high output is disclosed, nothing is mentioned about analysis and improvement of increase of the nonlinear state of the intensity characteristic B as mentioned above, and improvement of the frequency modulation efficiency.

### Disclosure of Invention

The present invention has been devised in the light of the above background, and it is an object of the present invention to provide a tunable wavelength semiconductor laser, capable of setting low a bias current value of a modulation signal to be applied for obtaining laser light whose wavelength varies at an amplitude determined by an absorption characteristic around an absorption central wavelength, and setting small a current amplitude of the modulation signal, thereby suppressing power consumption, and further capable of improving a nonlinear state of an intensity characteristic B and lowering modulation distortion of the laser light, and substantially enhancing the measuring precision of gas detection of a gas to be measured, and a gas detector having the tunable wavelength semiconductor laser incorporated therein.

According to a first aspect of the present invention, there is provided a tunable wavelength semiconductor laser (27) comprising:
an n-type semiconductor substrate (11);
an active layer (17) which is disposed above the n-type semiconductor substrate (11) and which generates light;
a p-type cladding layer (22) disposed above the active layer (17); and
wavelength selecting means (15) for causing to selectively oscillate only a specific wavelength from the light generated in the active layer (17),
the tunable semiconductor layer (27) capable of oscillating at the specific wavelength being performed by injecting current into the active layer (17), and the specific wavelength being varied by changing the magnitude of the current, wherein
a device length showing a length in a propagation direction of the light generated in the active layer (17) is about 200 µm to 500 µm, and
the p-type cladding layer (22) includes a lightly doped cladding layer (19) having a low impurity concentration and a heavily doped cladding layer (20) having a high impurity concentration which are sequentially arranged from the active layer (17) side.

In the thus configured tunable wavelength semiconductor laser of the first aspect, the device length L indicating the length in the propagation direction of the light generated in the active layer (17) is set in a range of about 200 µm to 500 µm.

Usually, the longer a device length L indicating a length in a propagation direction of light generated in an active layer in a tunable wavelength semiconductor laser, the larger is the area of an electrode to which current is applied or the area of the active layer, so that a current value per unit area drops, and temperature of the active layer of the tunable wavelength semiconductor laser is less likely to rise.

That is, in such a tunable wavelength semiconductor laser having the long device length L, temperature changes are small even if it is attempted to change heat generation by varying the applied current, and consequently, frequency modulation efficiency η showing the degree of wavelength change with respect to the applied current is low.

On the contrary, in a tunable wavelength semiconductor laser having a shortened device length L, the area of an electrode to which current is applied or the area of an active layer becomes smaller, so that a current value per unit area increases, and temperature of the active layer of the tunable wavelength semiconductor laser is likely to rise.

Thus, in such a tunable wavelength semiconductor laser having the short device length L, the temperature of the active layer changes easily if heat generation is changed by varying the applied current, and an oscillation wavelength λ changes, so that frequency modulation efficiency η showing the degree of wavelength change with respect to the applied current becomes higher.

Accordingly, in the tunable wavelength semiconductor laser having the short device length L, it is possible to set low a bias current value of a modulation signal to be applied for obtaining laser light whose wavelength varies at an amplitude determined by an absorption characteristic around an absorption central wavelength, and also set small a current amplitude of the modulation signal, thereby reducing power consumption.

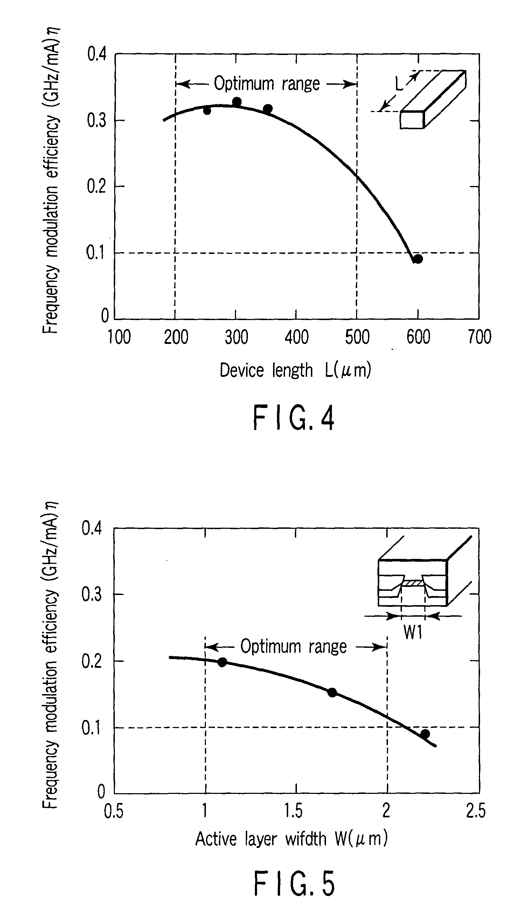

As a result of the experiments by the present inventors, in this kind of tunable wavelength semiconductor laser, the appropriate device length L is proved to be optimally in a range of about 200 µm to 500 µm as shown in FIG. 4.

Results shown in FIG. 4 are obtained by using a tunable wavelength semiconductor laser device having an active layer width of 2.2 µm.

In the tunable wavelength semiconductor laser (27) configured as shown in the first aspect of the invention, the p-type cladding layer (22) positioned above the active layer (17) is composed of a lightly doped cladding layer (19) and a heavily doped cladding layer (20) sequentially from the active layer (17) side.

Generally, in the semiconductor laser, it is important to illuminate and recouple carriers (electrons and holes) injected into the active layer at high probability as a technique for achieving a higher output.

For this purpose, it is desired to block the carriers overflowing from the active layer by p-type dopant of the cladding layer, and to reinforce carrier entrapment in the active layer.

By configuring the p-type cladding layer (22) positioned above the active layer (17) as mentioned above, electrons (carriers) overflowing from the active layer can be blocked by the heavily doped p-type cladding layer (20).

Further, diffusion of impurities such as Zn from the heavily doped p-type cladding layer (20) is arrested at the lightly doped p-type cladding layer (19) and does not reach up to the active layer (17).

As a result, while sufficiently blocking the carriers, diffusion of p-type dopant injected at the time of manufacturing the semiconductor laser into the active layer (17) is prevented, and high luminescence effect and high output can be obtained. Hence, the nonlinear state of the intensity characteristic B shown in FIG. 10A is improved, and modulation distortion of exit laser light is lowered.

It is therefore possible to enhance the detection precision of the gas detector having the tunable wavelength semiconductor laser incorporated therein.

According to a second aspect of the present invention, there is provided a tunable wavelength semiconductor laser (27) comprising:
an n-type semiconductor substrate (11);
an active layer (17) which is disposed above the n-type semiconductor substrate (11) and which generates light;
a p-type cladding layer (22) disposed above the active layer (17); and
wavelength selecting means (15) for causing to selectively oscillate only a specific wavelength from the light generated in the active layer (17),
the tunable wavelength semiconductor laser (27) capable of oscillating at the specific wavelength being performed by injecting current into the active layer (17), and the specific wavelength being varied by changing the magnitude of the current, wherein
a width of the active layer (17) orthogonal to a propagation direction of the light generated in the active layer (17), and showing a length in a direction parallel to the n-type semiconductor substrate is about 1 µm to 2 µm, and
the p-type cladding layer (22) includes a lightly doped cladding layer (19) having a low impurity concentration and a heavily doped cladding layer (20) having a high impurity concentration which are sequentially arranged from the active layer (17) side.

In the thus configured tunable wavelength semiconductor laser of the second aspect, the width W of the active layer indicating the length in the orthogonal direction to the propagation direction of the light generated in the active layer (17) is set in a range of about 1 µm to 2 µm.

Also in the width W of the active layer, the narrower the active layer width W, the smaller is the area of the active layer to which current is applied same as in the device length L mentioned above. Therefore, a current value per unit area increases, and temperature of the active layer of the tunable wavelength semiconductor laser is likely to rise.

That is, in a tunable wavelength semiconductor laser having a narrow active layer width W, temperature of an active layer rises easily when heat generation is changed by varying applied current, and an oscillation wavelength λ changes, so that frequency modulation efficiency η showing the degree of temperature change with respect to the applied current becomes higher.

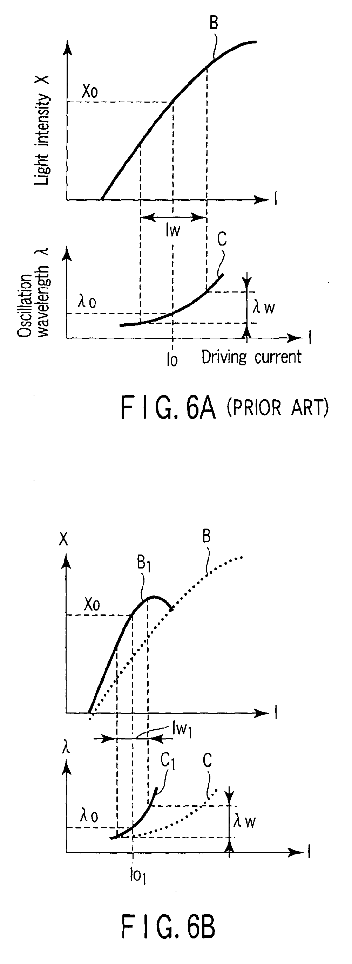

According to the experiments by the present inventors, as shown in FIG. 5, the active layer width W is proved to be optimally in a range of about 1 µm to 2 µm.

Results shown in FIG. 5 are obtained by using a tunable wavelength semiconductor laser device having a device length of 600 µm.

Therefore, the tunable wavelength semiconductor laser according to the second aspect of the invention brings about the substantially same effects as those of the tunable wavelength semiconductor laser according to the first aspect of the invention.

According to a third aspect of the present invention, there is provided a tunable wavelength semiconductor laser (27) comprising:
an n-type semiconductor substrate (11);
an active layer (17) which is disposed above the n-type semiconductor substrate (11) and which generates light;
a p-type cladding layer (22) disposed above the active layer (17); and
wavelength selecting means (15) for causing to selectively oscillate only a specific wavelength from the light generated in the active layer (17),
the tunable wavelength semiconductor laser (27) capable of oscillating at the specific wavelength being performed by injecting current into the active layer (17), and the specific wavelength being varied by changing the magnitude of the current, wherein
a device length showing a length in a propagation direction of the light generated in the active layer (17) is about 200 µm to 500 µm,
a width of the active layer (17) orthogonal to the propagation direction of the light generated in the active layer (17), and showing a length in a direction parallel to the n-type semiconductor substrate (11) is about 1 µm to 2 µm, and
the p-type cladding layer (22) includes a lightly doped cladding layer (19) having a low impurity concentration and a heavily doped cladding layer (20) having a high impurity concentration which are sequentially arranged from the active layer (17) side.

In the thus configured tunable wavelength semiconductor laser of the third aspect, the device length L indicating the length in the propagation direction of the light generated in the active layer (17) is set in a range of about 200 µm to 500 µm, and the width W of the active layer (17) is set in a range of about 1 µm to 2 µm.

Therefore, the tunable wavelength semiconductor laser according to the third aspect of the invention brings about combined effects of the tunable wavelength semiconductor lasers according to the first and second aspects.

According to a fourth aspect of the present invention, there is provided a gas detector comprising:
a semiconductor laser module (1a) having a tunable wavelength semiconductor laser incorporated therein, the semiconductor laser module emitting laser light modulated in wavelength at a specified frequency;
a photoreceiver (4) which receives laser light to convert into an electrical signal, the laser light being emitted from the semiconductor laser module (1a) and having passed through a gas to be measured; and
a gas detection unit (6) which detects the gas to be measured on the basis of the electrical signal outputted from the photoreceiver (4),
the tunable wavelength semiconductor laser (27) incorporated in the semiconductor laser module (1a) comprising:
   an n-type semiconductor substrate (11);
   an active layer (17) which is disposed above the n-type semiconductor substrate (11) and which generates light;
   a p-type cladding layer (22) disposed above the active layer (17); and
   wavelength selecting means (15) for causing to selectively oscillate only a specific wavelength from the light generated in the active layer (17),
   the tunable wavelength semiconductor laser (27) capable of oscillating at the specific wavelength being performed by injecting current into the active layer (17), and the specific wavelength being varied by changing the magnitude of the current, wherein
   a device length showing a length in a propagation direction of the light generated in the active layer (17) is about 200 µm to 500 µm, and
   the p-type cladding layer (22) includes a lightly doped cladding layer (19) having a low impurity concentration and a heavily doped cladding layer (20) having a high impurity concentration which are sequentially arranged from the active layer (17) side.

According to a fifth aspect of the present invention, there is provided a gas detector comprising:
a semiconductor laser module (1a) having a tunable wavelength semiconductor laser incorporated therein, the semiconductor laser module emitting laser light modulated in wavelength at a specified frequency;
a photoreceiver (4) which receives laser light to convert into an electrical signal, the laser light being emitted from the semiconductor laser module (1a) and having passed through a gas to be measured; and
a gas detection unit (5) which detects the gas to be measured on the basis of the electrical signal output from the photoreceiver (4),
the tunable wavelength semiconductor laser (27) incorporated in the semiconductor laser module (1a) comprising:
   an n-type semiconductor substrate (11);
   an active layer (17) which is disposed above the n-type semiconductor substrate (11) and which generates light;
   a p-type cladding layer (22) disposed above the active layer (17); and
   wavelength selecting means (15) for causing to selectively oscillate only a specific wavelength from the light generated in the active layer (17),
   the tunable wavelength semiconductor laser (27) capable of oscillating at the specific wavelength being performed by causing current to flow into the active layer (17), and the specific wavelength being varied by changing the magnitude of the current, wherein
   a width of the active layer (17) orthogonal to a propagation direction of the light generated in the active layer (17), and showing a length in a direction parallel to the n-type semiconductor substrate (11) is about 1 µm to 2 µm, and
   the p-type cladding layer (22) includes a lightly doped cladding layer (19) having a low impurity concentration and a heavily doped cladding layer (20) having a high impurity concentration which are sequentially arranged from the active layer (17) side.

According to a sixth aspect of the present invention, there is provided a gas detector comprising:
a semiconductor laser module (1a) having a tunable wavelength semiconductor laser incorporated therein, the semiconductor laser module emitting laser light modulated in wavelength at a specified frequency;
a photoreceiver (4) which receives laser light to convert into an electrical signal, the laser light being emitted from the semiconductor laser module (1a) and having passed through a gas to be measured; and
a gas detection unit (5) which detects the gas to be measured on the basis of the electrical signal output from the photoreceiver (4),
the tunable wavelength semiconductor laser (27) incorporated in the semiconductor laser module (1a) comprising:
   an n-type semiconductor substrate (11);
   an active layer (17) which is disposed above the n-type semiconductor substrate (11) and which generates light;
   a p-type cladding layer (22) disposed above the active layer (17); and
   wavelength selecting means (15) for causing to selectively oscillate only a specific wavelength from the light generated in the active layer (17),
   the tunable wavelength semiconductor laser (27) capable of oscillating at the specific wavelength being performed by causing current to flow into the active layer (17), and the specific wavelength being varied by changing the magnitude of the current, wherein
   a device length showing a length in a propagation direction of the light generated in the active layer (17) is about 200 µm to 500 µm,
   a width of the active layer (17) orthogonal to the propagation direction of the light generated in the active layer (17), and showing a length in a direction parallel to the n-type semiconductor substrate (11) is about 1 µm to 2 µm, and
   the p-type cladding layer (22) includes a lightly doped cladding layer (19) having a low impurity concentration and a heavily doped cladding layer (20) having a high impurity concentration which are sequentially arranged from the active layer (17) side.

In the tunable wavelength semiconductor laser having such a configuration and the gas detector having the tunable wavelength semiconductor laser incorporated therein, it is possible to set low the bias current value of the modulation signal to be applied for obtaining laser light whose wavelength varies at an amplitude determined by an absorption characteristic around an absorption central wavelength, and to set small a current amplitude of the modulation signal, thereby suppressing the power consumption. In addition, it is possible to improve a nonlinear state of the intensity characteristic B and lowering modulation distortion of exit laser light, and to substantially enhance the measuring precision of gas detection of a gas to be detected.

In the first to sixth aspects of the invention, it is preferable that, when the p-type cladding layer (22) has Zn as a p-type impurity, the impurity concentration of the lightly doped cladding layer (19) is undoped or about 3 × 10¹⁷/cm³, and the impurity concentration of the heavily doped cladding layer (20) is about 1 × 10¹⁸/cm³.

In the first to sixth aspects of the invention, the concentration of the heavily doped cladding layer (20) is desirably 8 × 10¹⁷/cm³ or more at peak, and the concentration of the lightly doped cladding layer (19) is desirably undoped or 4 × 10¹⁷/cm³ or less, with a thickness of about 30 nm to 70 nm.

In the first to sixth aspects of the invention, it is preferable that the p-type cladding layer (22) further includes a moderately doped cladding layer (21) having a medium impurity concentration, the moderately doped cladding layer being arranged sequentially to the heavily doped cladding layer (20).

In the first to sixth aspects of the invention, it is preferable that, when the p-type cladding layer (22) has Zn as a p-type impurity, the impurity concentration of the moderately doped cladding layer (21) is about 5 × 10¹⁷/cm³.

In the first to sixth aspects of the invention, it is preferred to include a lower separate confinement heterostructure (SCH) layer (16) which is formed above the n-type semiconductor substrate (11) by way of a spacer layer (10); a multiquantum well (MQW) layer which is formed above the lower SCH layer (16) as the active layer (17); and an upper SCH layer (18) which is formed above the active layer (17).

In the first to sixth aspects of the invention, it is preferred that an upper part of the n-type semiconductor substrate (11), the wavelength selecting means (15), the lower SCH layer (16), the active layer (17), the upper SCH layer (18) and part of the p-type cladding layer (22) are formed in a mesa shape, and that a p-type embedded layer (25) and an n-type embedded layer (26) are formed at both sides of the mesa from the downside.

In the first to sixth aspects of the invention, it is preferred that any one of a distributed feedback type (DFB), a distributed reflection type (DR), a distributed Bragg reflection-type (DBR), a partial diffraction grating type (PC), and an external cavity type (EC) is employed as the structure of the tunable wavelength semiconductor laser (27).

### Brief Description of Drawings

FIG. 1 is a cut-away view of a tunable wavelength semiconductor laser according to a first embodiment of the invention, taken along a light propagation direction.
FIG. 2 is a sectional view taken along line II-II in FIG. 1.
FIG. 3 is a view showing an impurity concentration distribution of a p-type cladding layer in the tunable wavelength semiconductor laser according to the first embodiment of the invention.
FIG. 4 is a view showing the relation between a device length L and frequency modulation efficiency η in the tunable wavelength semiconductor laser according to the first embodiment of the invention.
FIG. 5 is a view showing the relation between a active layer width W and frequency modulation efficiency η in the tunable wavelength semiconductor laser according to the first embodiment of the invention.
FIG. 6A is a view showing characteristics of a conventional semiconductor laser.
FIG. 6B is a view showing an example of characteristics of the tunable wavelength semiconductor laser according to the first embodiment of the invention.
FIG. 6C is a view showing another example of characteristics of the tunable wavelength semiconductor laser according to the first embodiment of the invention.
FIG. 7 is a schematic diagram showing a configuration of a gas detector according to a second embodiment of the invention.
FIG. 8 is a schematic diagram showing a configuration of a semiconductor laser module and a laser drive control unit incorporated in the gas detector according to the second embodiment of the invention.
FIG. 9 is a view showing the relation between an absorption characteristic of a gas to be measured and a modulation signal according to a conventional gas detector.
FIG. 10A is a view showing a light intensity characteristic of a semiconductor laser incorporated in the conventional gas detector.
FIG. 10B is a view showing an oscillation wavelength characteristic of the semiconductor laser incorporated in the conventional gas detector.
FIG. 11 is a connection diagram explaining tunability of the tunable wavelength semiconductor laser according to the first embodiment of the invention.
FIG. 12 is a waveform chart of a heterodyne beat signal, for explaining tunability of the tunable wavelength semiconductor laser according to the first embodiment of the invention.

### Best Mode for Carrying Out the Invention

Embodiments of a tunable wavelength semiconductor laser of the invention and a gas detector having the tunable wavelength semiconductor laser incorporated therein will be described below with reference to the accompanying drawings.

### (First embodiment)

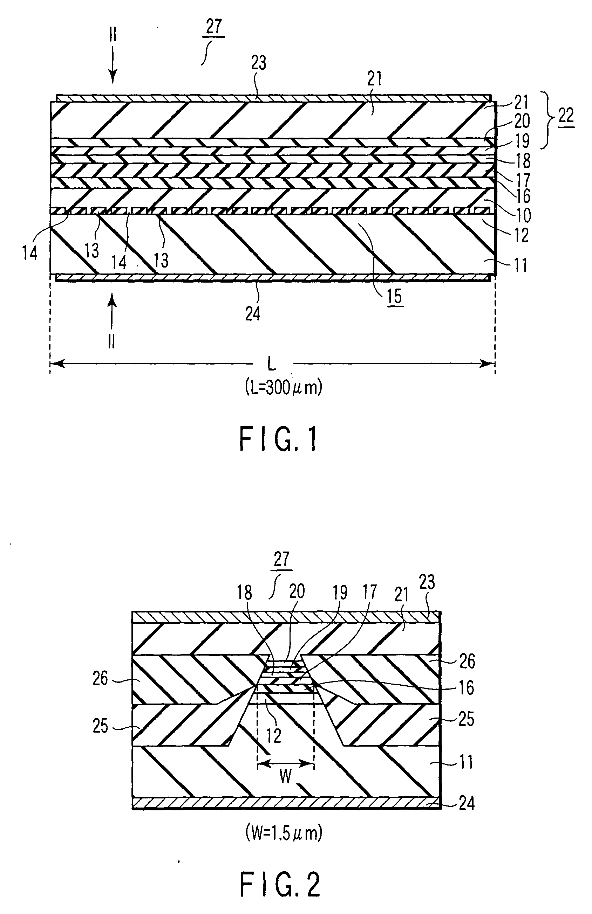

FIG. 1 is a cut-away view of a tunable wavelength semiconductor laser according to a first embodiment of the invention, taken along a light propagation direction. FIG. 2 is a sectional view of the tunable wavelength semiconductor laser, taken along line II-II in FIG. 1.

A tunable wavelength semiconductor laser 27 of the first embodiment is composed of a distributed feedback (DFB) semiconductor laser.

That is, as shown in FIG. 1, in the tunable wavelength semiconductor laser 27, a diffraction grating layer 12 made of n-type InGaAsP is formed on the upside of an n-type semiconductor substrate 11 made of n-type InP.

The diffraction grating layer 12 is composed of plural gratings 13, and wavelength selecting means 15 having plural gaps 14 existing between the plural gratings 13 mutually.

The gaps 14 are filled with a spacer layer 10 made of n-type InP.

Above the n-type semiconductor substrate 11, there are formed a lower separate confinement heterostructure (SCH) layer 16 made of InGaAsP, an active layer 17 formed of a multiquantum well (MQW) layer, and an upper SCH layer 18 having respective proper compositions.

A p-type cladding layer 22 made of p-type InP is formed on the upside of the upper SCH layer 18.

The p-type cladding layer 22 includes a lightly doped.cladding layer 19 having a low impurity concentration and a heavily doped cladding layer 20 having a high impurity concentration sequentially from the upper SCH layer 18 side.

Herein, the heavily doped cladding layer 20 blocks carriers from the active layer 17, and the lightly doped cladding layer 19 prevents Zn as the impurity from diffusing into the active layer 17.

In order to obtain these effects, the concentration of the lightly doped cladding layer 20 is desired to be 8 × 10¹⁷/cm³ or more at peak, and the concentration of the lightly doped cladding layer 19 is desired to be undoped or 4 × 10¹⁷/cm³ or less, with a thickness of about 30 nm to 70 nm.

This is because when the thickness of the lightly doped cladding layer 19 is less than 30 nm, Zn used as the impurity is diffused up to the active layer 17, and the luminescent characteristic is impaired, and when the thickness is larger than 70 nm, on the other hand, carriers are gathered in the lightly doped cladding layer 19, and carrier blocking effect cannot be obtained.

Since the function of the heavily doped cladding layer 20 is to block carriers overflowing from the active layer 17, the heavily doped cladding layer 20 is not required to cover the entire cladding layer usually having a thickness of several units of µm, and the upside of the heavily doped cladding layer 20 may be formed of a moderately doped cladding layer 21 having an intermediate concentration between low concentration and high concentration.

As far as the thickness of the heavily doped cladding layer 20 is 30 nm or more, the peak value can be kept at 7 × 10¹⁷/cm³ or more even if the concentration is decreased by diffusion.

On the other hand, the concentration of the moderately doped cladding layer 21 is preferred to be 5 × 10¹⁷/cm³ to 7 × 10¹⁷/cm³.

That is, if the concentration of the moderately doped cladding layer 21 is too low, the electrical resistance increases and excessive heat generation is induced, and the device characteristic deteriorates, and on the other hand, if the concentration of the moderately doped cladding layer 21 is too high, absorption between valence bands is increased and loss of light increases, so that it is not advantageous for high output operation.

In this embodiment, explanation is given for the structure having the lightly doped cladding layer (lightly doped p-type cladding layer) 19, the heavily doped cladding layer (heavily doped p-type cladding layer) 20, and the moderately doped cladding layer (moderately doped p-type cladding layer) 21 sequentially formed from the upper SCH layer 18 side as the p-type cladding layer 22.

FIG. 3 is a view showing an impurity concentration distribution using Zn as a p-type impurity in the p-type cladding layer 22.

The impurity concentration of the lightly doped cladding layer 19 is undoped or about 3 × 10¹⁷/cm³, and the impurity concentration of the heavily doped cladding layer 20 is about 1 × 10¹⁸/cm³.

The impurity concentration distribution using Zn as a p-type impurity in the p-type cladding layer 22 shown in FIG. 3 is also disclosed in Patent document 2 (USP 6,351,479) by the present inventors or the like mentioned above. However, nothing has been discussed about analysis and improvement of increase of a nonlinear state of an intensity characteristic B, and improvement of frequency modulation efficiency, which are important subjects of the invention as explained later.

The impurity concentration of the moderately doped cladding layer 21 is about 5 × 10¹⁷/cm³.

A p-electrode 23 is provided on the upside of p-type cladding layer 22 by way of a contact layer (not shown) made of p-type InGaAs, and an n-electrode 24 is provided on the downside of the n-type semiconductor substrate 11.

A device length L in a light propagation direction of the tunable wavelength semiconductor laser 27 is 300 µm.

As shown in the sectional view in FIG. 2, an upper part of the n-type semiconductor substrate 11, the diffraction grating layer 12, the lower SCH layer 16, the active layer 17, the upper SCH layer 18, and part of the p-type cladding layer 22 are formed in a mesa shape.

At both sides of the mesa, a p-type embedded layer 25 made of p-type InP and an n-type embedded layer 26 made of n-type InP are formed from the downside.

The active layer width W of the active layer 17 in a direction orthogonal to the light propagation direction of the tunable wavelength semiconductor laser 27 is set at 1.5 µm.

In the tunable wavelength semiconductor laser 27 of the first embodiment having such a configuration, when a driving current I is applied between the p-electrode 23 and the n-electrode 24, the active layer 17 releases lights having multiple wavelengths. However, among the lights having wavelengths, the light having a single wavelength λ determined by the period, equivalent refractive index, and temperature of the diffraction grating layer 12 is selected, and is output as laser light "a" from the tunable wavelength semiconductor laser.

Features of the tunable wavelength semiconductor laser 27 of the first embodiment having such a configuration will be explained below.

FIG. 4 is a characteristic view showing the relation between the device length L and the frequency modulation efficiency η, in which plural types of semiconductor lasers differing only in the device length L, 250 µm ± 10%, 300 µm ± 10%, 350 µm ± 10%, and 600 µm ± 10% are formed, the semiconductor lasers having the same structure as the tunable wavelength semiconductor laser 27 of the first embodiment, and using methane as the gas to be detected as described above, and the frequency modulation efficiency η in each semiconductor laser is measured.

When the tunable wavelength semiconductor laser 27 is used for a laser light source of a gas analyzer, the frequency modulation efficiency η required from the power consumption, modulation distortion of laser light and the like is 0.1 GHz/mA or more.

It is extremely difficult to manufacture semiconductor lasers with the device length L of less than 20 µm stably at the current manufacturing technical level, and the light output is also lowered.

Therefore, the device length L of the tunable wavelength semiconductor laser 27 is optimally in a range of about 200 µm to 500 µm (more preferably, about 250 µm to 450 µm).

Since it is not required to modulate the wavelength of exit laser light in a conventional general semiconductor laser, frequency modulation efficiency η is not taken into consideration, and considering heat generation in order to maximize the output, the device length L is set at 600 µm or more.

Thus, in the tunable wavelength semiconductor laser 27 of the first embodiment, the device length L is set at about 200 µm to 500 µm which is shorter than that of the conventional semiconductor laser. Accordingly, a sufficient frequency modulation efficiency η can be assured, and as mentioned above, in order to obtain laser light "a" whose wavelength λ varies at the amplitude λ_{W} determined by the absorption characteristic A of the gas to be measured around the absorption central wavelength λ₀, the bias current value I₀ of the modulation signal b to be applied can be set lower, and the current amplitude I_{W} of the modulation signal b can be also set smaller, so that the power consumption can be reduced.

FIG. 5 is a characteristic view showing the relation between the active layer width W and the frequency modulation efficiency η, in which plural types of semiconductor lasers differing only in the active layer width W, 1.1 µm ± 10%, 1.7 µm ±.10%, and 2.2 µm ± 10% are formed, the semiconductor lasers having the same structure as the tunable wavelength semiconductor laser 27 of the first embodiment, and using methane as the gas to be detected as described above, and the frequency modulation efficiency η in each semiconductor laser is measured.

As mentioned above, in this kind of tunable wavelength semiconductor laser, the frequency modulation efficiency η is required to be 0.1 GHz/mA or more.

It is extremely difficult to manufacture semiconductor lasers with the active layer width W of less than 1 µm stably at the current manufacturing technical level, and further, a sufficient gain is not obtained in the semiconductor laser with the active layer width W of less than 1 µm, so that the light output is lowered extremely.

Therefore, the active layer width W of the tunable wavelength semiconductor laser 27 is optimally in a range of about 1 µm to 2 µm.

Since it is not required to modulate the wavelength of exit laser light in a conventional general semiconductor laser, the frequency modulation efficiency η is not taken into consideration, and considering heat generation in order to maximize the output, the active layer width W is set at 2 µm or more.

Thus, in the tunable wavelength semiconductor laser 27 of the first embodiment, the active layer width W is set at about 1 µm to 2 µm which is shorter than that of the conventional semiconductor laser. Accordingly, a sufficient frequency modulation efficiency η can be assured, and as mentioned above, in order to obtain laser light "a" whose wavelength λ varies at the amplitude λ_{W} determined by the absorption characteristic A of the gas to be measured around the absorption central wavelength λ₀, the bias current value I₀ of the modulation signal b to be applied can be set lower, and the current amplitude I_{W} of the modulation signal b can be also set smaller, so that the power consumption can be reduced.

Further, in the tunable wavelength semiconductor laser 27 of the first embodiment, the p-type cladding layer 22 positioned above the active layer 17 is composed of the lightly doped cladding layer 19 having a low impurity concentration, the heavily doped cladding layer 20 having a high impurity concentration, and the moderately doped cladding layer 21 having an intermediate impurity concentration for suppressing absorption of light in holes in the p-type cladding layer 22, sequentially from the active layer 17 side.

In the tunable wavelength semiconductor laser 27 of the first embodiment, the p-type cladding layer 22 is composed of the plural layers 19, 20, 21 differing in impurity concentration. Accordingly, as mentioned above, carriers overflowing from the active layer 17 can be sufficiently blocked, diffusion of p-type dopant into the active layer 17 is prevented, and light absorption in the p-type cladding layer 22 is minimized, so that high luminescence efficiency and high output can be obtained.

Therefore, since the nonlinear state of the intensity characteristic B shown in FIG. 10A is improved in the tunable wavelength semiconductor laser 27 of the first embodiment, modulation distortion of exit laser light can be lowered.

From the viewpoint of improvement of the nonlinear state of the intensity characteristic B shown in FIG. 10A, the moderately doped cladding layer 21 is not always necessary in the tunable wavelength semiconductor laser 27 of the first embodiment.

Hence, the gas detector having the tunable wavelength semiconductor laser 27 of the first embodiment incorporated therein is enhanced in detection precision.

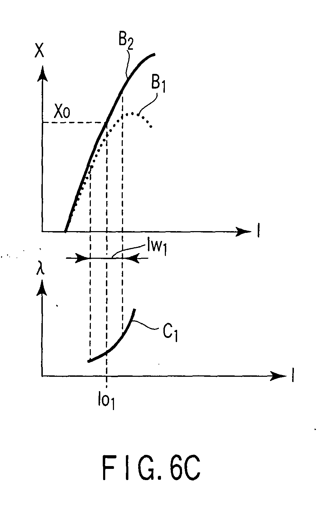

FIGS. 6A, 6B and 6C show the characteristic of the tunable wavelength semiconductor laser 27 of the first embodiment and the characteristic of the conventional semiconductor laser in comparison with each other, in order to explain the effect of shortening the device length L and the active layer width W of the tunable wavelength semiconductor laser 27 of the first embodiment, and the effect of forming the heavily doped cladding layer 20 on the p-type cladding layer 22.

FIG. 6A shows intensity characteristic B and wavelength characteristic C of the conventional semiconductor laser.

FIG. 6B shows intensity characteristic B₁ and wavelength characteristic C₁ of a tunable wavelength semiconductor laser in which the device length L is shortened to about 300 µm and the width W of the active layer 17 is shortened to about 1.5 µm in the tunable wavelength semiconductor laser 27 of the first embodiment of the invention.

According to the intensity characteristic B₁ and wavelength characteristic C₁ of the tunable wavelength semiconductor laser 27 of the first embodiment shown in FIG. 6B, in order to obtain the central wavelength λ₀ and light intensity X₀ necessary in the frequency modulated exit laser light "a", a bias current value (current value I₀₁) of a modulation signal b to be applied to the tunable wavelength semiconductor laser is substantially lowered as compared with the bias current value (current value I₀) of the conventional semiconductor laser in FIG. 6A, so that power consumption can be reduced.

Further, according to the intensity characteristic B₁ and wavelength characteristic C₁ of the tunable wavelength semiconductor laser 27 of the first embodiment shown in FIG. 6B, in order to obtain amplitude λ_{W} necessary in the frequency modulated exit laser light "a", an amplitude I of the modulation signal b to be applied to the tunable wavelength semiconductor laser 27 in the first embodiment is substantially lowered as compared with the amplitude I_{W} of the conventional semiconductor laser in FIG. 6A, so that power consumption can be reduced.

FIG. 6C shows intensity characteristic B₂ and wavelength characteristic C₂ of a tunable wavelength semiconductor laser 27 in which the device length L and the width W of the active layer 17 are shortened to 300 µm and 1.5 µm, respectively, in the tunable wavelength semiconductor laser 27 of the first embodiment of the invention, and further having the heavily doped cladding layer 20 on the p-type cladding layer 22.

According to the intensity characteristic B₂ of tunable wavelength semiconductor laser 27 of the first embodiment shown in FIG. 6C, as compared with the intensity characteristic B of the conventional semiconductor laser shown in FIG. 6A and the intensity characteristic B₁ of the tunable wavelength semiconductor laser shown in FIG. 6B, the nonlinear state is improved substantially, and the modulation distortion of the exit laser light "a" can be lowered.

As a result, the gas detector having the tunable wavelength semiconductor laser 27 incorporated therein is enhanced in the precision of detection.

Tunability of the tunable wavelength semiconductor laser 27 of the first embodiment will be explained.

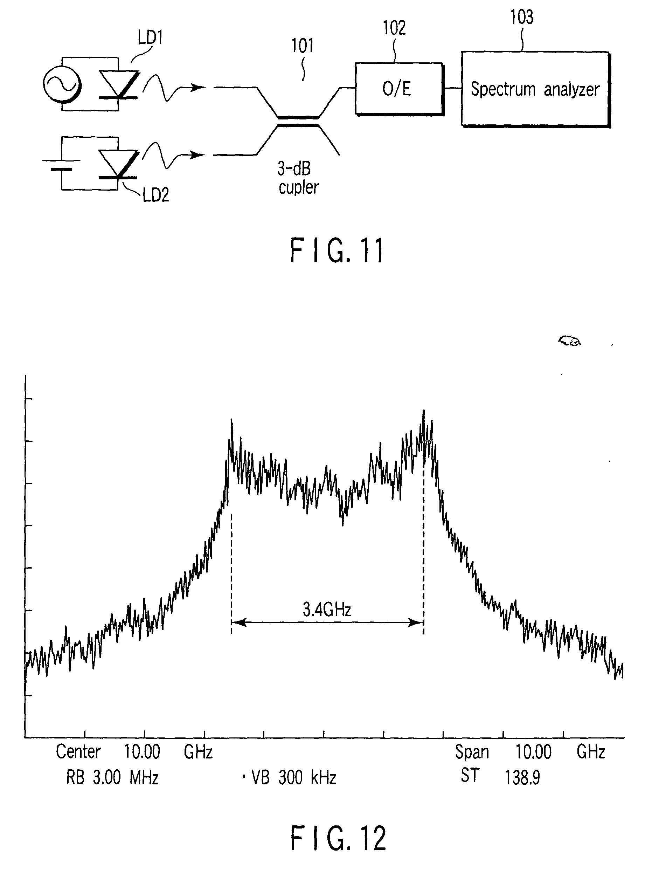

FIG. 11 is a connection diagram for explaining tunability of the tunable wavelength semiconductor laser 27 according to the first embodiment of the invention.

FIG. 12 is a waveform chart of a heterodyne beat signal, for explaining tunability of the tunable wavelength semiconductor laser 27 according to the first embodiment of the invention.

Tunability is determined by a measuring apparatus configuration as shown in FIG. 11, by a heterodyne beat system.

A laser diode LD1 as a test chip is modulated by a sinusoidal signal of frequency 10 kHz and amplitude 5 mA (peak to peak 10 mA) biased at 50 mA.

The other laser diode LD2 for obtaining probe light as reference light is operated by DC, and the wavelength of the laser light is close to the wavelength of the laser light of the modulated laser diode LD1.

The laser diodes LD1 and LD2 are coupled to a SiC block and mounted, and thermally controlled by a thermoelectric cooler. Both the laser lights from the laser diodes LD1 and LD2 are focused and coupled via a 3-dB coupler 101 and an optical isolator (not shown). The coupled laser light is detected by an opto-electrical (O/E) converter 102, and its output signal is observed by a spectrum analyzer 103.

FIG. 12 shows that the laser diode LD1 as a test chip has the tunability of about 0.68 GHz/mA at 10 kHz.

The R(3) absorption line of methane has full width at half-maximum (FWHM) of about 3.4 GHz at room temperature and atmospheric pressure, and the laser diode LD1 as a test chip can vary the wavelength over the entire FWHM of methane by modulation of 12 mA. These characteristics support a sufficient use as a portable battery powered methane sensor.

That is, the method of measuring tunability by using the heterodyne beat system can obtain the most useful data when the tunable wavelength semiconductor laser 27 in the first embodiment of the invention is used in a gas detector of a second embodiment of the invention described later, and characteristics of the tunable wavelength semiconductor laser 27 can be compared.

In FIG. 12, an upper laser diode LD (hereinafter referred to as LD1) is the tunable wavelength semiconductor laser 27 of the first embodiment of the invention, and corresponds to the laser diode as a test chip and modulated laser diode LD1.

The laser diode LD1 is modulated at amplitude 5 mA (10 mA peak to peak), for example, around 50 mA, and the wavelength of light (light frequency) output from the laser diode LD1 is also modulated corresponding to the modulation.

In FIG. 11, a lower laser diode LD (hereinafter referred to as LD2) corresponds to the other laser diode LD2 for obtaining probe light as the reference light.

Since the laser diode LD2 operates on DC, the light wavelength (light frequency) is fixed, and the wavelength of light from the laser diode LD2 is close to that of the laser diode LD1 (that is, the differential frequency of LD1 and LD2 is within the band of the O/E converter described below).

The light from the laser diode LD1 and the light from the laser diode LD2 are combined by the 3-dB coupler 101, the combined light is received at the O/E converter 102, and an electrical signal (beat) having a differential frequency of both diodes is observed by the spectrum analyzer 103.

Since injection current into the laser diode LD 1 is modulated, the frequency difference of both lights of the laser diode LD1 and the laser diode LD2 also changes corresponding to the modulation, that is, the frequency of beat also changes corresponding to the modulation.

When the vicinity of the frequency of the beam is magnified (magnified on the abscissa) by the spectrum analyzer, the beat frequency is changed to 3.4 GHz as shown in FIG. 12, and the frequency tunable width of the laser diode LD1 is estimated at 3.4 GHz.

The data corresponds to the characteristic in the case of the device length L = 350 µm and the active layer width W = 1.7 µm of the tunable wavelength semiconductor laser 27 of the first embodiment, and an average of 0.60 GHz/mA is obtained.

Although not shown in the figure, in the characteristic in the case of the device length L = 300 µm and the active layer width W = 2.2 µm of the tunable wavelength semiconductor laser 27 of the first embodiment, an average of about 0.25 GHz/mA is obtained.

Out of the scope of the invention, in the conventional semiconductor laser with the device length L = 600 µm and the active layer width W = 2.2 µm of the tunable wavelength semiconductor laser 27 of the first embodiment, an average is about 0.08 GHz/mA.

By such comparison, it is known that the tunability of the tunable wavelength semiconductor laser 27 of the first embodiment has a tunability of at least three times to seven times or more as compared with the conventional semiconductor laser.

### (Second embodiment)

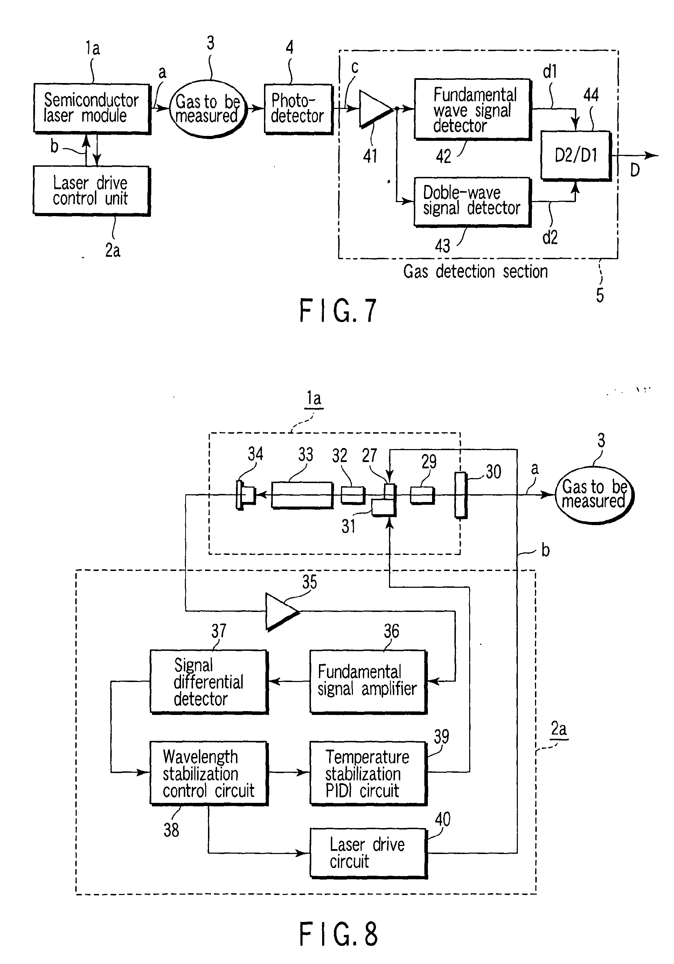

FIG. 7 is a schematic diagram showing a configuration of a gas detector according to a second embodiment of the invention.

The gas detector according to the second embodiment incorporates the tunable wavelength semiconductor laser 27 according to the first embodiment in a semiconductor laser module 1a.

Laser light "a" emitted from the semiconductor laser module 1a having the tunable wavelength semiconductor laser 27 incorporated therein passes through a gas 3 to be measured composed of, for example, methane, and is detected by a photoreceiver 4. The gas 3 composed of methane has an absorption characteristic A having an absorption central wavelength λ₀ = 1.6537 µm, for example, as shown in FIG. 9.

A laser drive control unit 2a sends out a modulation signal b to the tunable wavelength semiconductor laser 27 incorporated in the semiconductor laser module 1a.

FIG. 8 is a schematic diagram showing a configuration of the semiconductor laser module 1a and the laser drive control unit 2a.

The tunable wavelength semiconductor laser 27 is controlled in temperature by a Peltier element 31.

The laser light "a" emitted from one exit facet of the tunable wavelength semiconductor laser 27 is sent outside of the semiconductor laser module 1a via a focusing lens 29 and a protective glass 30, and is made to be incident on the gas 3 to be measured.

Laser light emitted from the other exit facet of the tunable wavelength semiconductor laser 27 is converted onto parallel light by a focusing lens 32, passes through a reference gas cell 33 filled with the same methane gas as the gas 3 to be measured as reference gas, and is made to be incident on a photoreceiver 34.

The photoreceiver 34 converts the intensity of the incident laser light into an electrical (current) signal, and inputs the signal into a current-voltage converter 35 in the laser drive control unit 2a.

The laser drive control unit 2a is composed of the current-voltage converter 35, a fundamental wave signal amplifier 36, a signal differential detector 37, a wavelength stabilization control unit 38, a temperature stabilization PID circuit 39, and a laser drive circuit 40.

The current-voltage converter 35 converts the electrical signal of the photoreceiver 34 into voltage. The fundamental wave signal amplifier 36 amplifies the voltage converted by the current-voltage converter 35. The signal differential detector 37 differentiates the voltage waveform amplified by the fundamental wave signal amplifier 36, and generates a deviation signal from the absorption central wavelength λ₀ of reference gas.

The wavelength stabilization control unit 38 controls to stabilize the emission wavelength λ of the tunable wavelength semiconductor laser 27 at the absorption central wavelength λ₀ of reference gas.

That is, the wavelength stabilization control circuit 38 converts the deviation signal from the signal differential detector 37 into temperature of the tunable wavelength semiconductor laser 27, and outputs it to the temperature stabilization PID circuit 39 and also outputs a control signal to the laser drive circuit 40 on the basis of the deviation signal.

The temperature stabilization PID circuit 39 controls the Peltier element 31. That is, the temperature stabilization PID circuit 39 performs PID control such that the tunable wavelength semiconductor laser 27 is controlled to a temperature for oscillating at a desired wavelength in accordance with the temperature signal from the wavelength stabilization control circuit 38, and maintains the temperature of the tunable wavelength semiconductor laser 27 stably at a specific temperature.

The laser drive circuit 40 applies a modulation signal b with the amplitude I_{W} and the modulation frequency f₁ = 10 kHz to the tunable wavelength semiconductor laser 27 incorporated in the semiconductor laser module la, around a central current value I₀₁ (bias current value), that is, the central current value I₀₁ (bias current value) is a value corresponding to the absorption central wavelength λ₀ of the absorption characteristic A shown in FIG. 9 of reference gas (gas 3 to be measured) at the oscillation wavelength λ of the tunable wavelength semiconductor laser 27.

As a result, the semiconductor laser module 1a outputs laser light "a" whose wavelength λ varies at the amplitude λ_{W} and at the frequency f₁ = 10 kHz, around the absorption central length λ₀.

The laser control circuit 40 control the central current value I₀₁ (bias current value) so as to obtain the wavelength characteristic mentioned above in the output laser light "a" in accordance with the control signal from the wavelength stabilization control circuit 38.

Accordingly, in the gas detector according to the second embodiment, by causing the gas emitted from the tunable wavelength semiconductor laser 27 to pass through the reference gas cell 33 filled with the same methane gas as the gas 3 to be measured, the temperature of the tunable wavelength semiconductor laser 27 and the central current value I₀₁ (bias current value) of the modulation signal b applied to the tunable wavelength semiconductor laser 27 are automatically controlled such that the central wavelength of this laser light coincides with the absorption central wavelength λ₀ of the absorption characteristic A shown in FIG. 9 of reference gas (gas 3 to be measured).

In FIG. 7, the laser light "a" emitted from the semiconductor laser module 1a and modulated in wavelength around the absorption central wavelength λ₀ is absorbed according to the absorption characteristic A as shown in FIG. 9 in the process of passing through the gas 3 to be measured, is received by the photoreceiver 4 and converted into an electrical (current) signal, and is input into a gas detection unit 5. Since the photoreceiver 4 does not have wavelength resolving capability of laser light "a", an electrical (current) signal c has a frequency component of the order of the modulation frequency.

The gas detection unit 5 is composed of a current-voltage converter 41, a fundamental wave signal detector 42, a double-wave signal detector 43, and a divider 44. The current-voltage converter 41 converts the electrical (current) signal "c" of the input current into an electrical signal c of voltage, and sends the signal to the fundamental wave signal detector 42 and double-wave signal detector 43.

The fundamental wave signal detector 42 extracts a fundamental wave signal d₁ as a signal component of modulation frequency f₁ = 10 kHz contained in the input electrical signal "c", and sends out to the divider 44.

The double-wave signal detector 43 extracts a double-wave signal d₂ as a signal component of modulation frequency f₂ (= 20 kHz) which is double the modulation frequency f₁ = 10 kHz contained in the input electrical signal "c", and sends out to the divider 44.

The divider 44 calculates a ratio (D₂/D₁) between an amplitude D₂ of the double-wave signal d₂ and an amplitude D₁ of the fundamental wave signal d₁, and sends out the calculated ratio (D₂/D₁) as a detection value D (= D₂/D₁) corresponding to the gas concentration.

In the gas detector having such a configuration, as the semiconductor laser to be incorporated in the semiconductor laser module 1a for emitting the laser light "a" incident into the gas 3 to be measured, there is employed the tunable wavelength semiconductor laser 27 in which the device length L is shortened to about 300 µm and the active layer width W is shortened to about 1.5 µm, and a heavily doped cladding layer 20 is further provided in the p-type cladding layer 22.

Therefore, the gas detector can reduce power consumption in the semiconductor laser module 1a and laser drive control unit 2a, and substantially suppresses modulation distortion of the laser light "a" incident into the gas 3 to be measured, so that the precision of measurement of the gas 3 is improved outstandingly.

The invention relates to the tunable wavelength semiconductor laser for controlling the light output and oscillation wavelength simultaneously by a single current, and the gas detector using the same.

Hence, specific structures of the semiconductor laser include a distributed feedback type (DFB), a distributed reflection type (DR), a distributed Bragg reflection-type (DBR), a partial diffraction grating type (PC), and an external cavity type (EC).

Aside from methane, the gas 3 to be measured in the invention includes, for example, the following shown together with the representative absorption line wavelengths in parentheses.

HCl (1.74 µm), NO (1.8 µm), CO (1.57 µm), N₂O (1.96 µm), NH₃ (1.54 µm), HF (1.3 µm), H₂O (1.38 µm), H₂S (1.57 µm), C₂H₂ (1.51 to 1.54 µm), HCN (1.53 to 1.56 µm), and CO₂ (2.0 µm).

As for the substrate and material, an epitaxial material is grown on an InP substrate in the embodiments, but not limited to them, and other materials such as GaN and GaAs systems can be used.

Therefore, according to the invention, there can be provided a tunable wavelength semiconductor laser in which, in order to obtain the laser light whose wavelength varies at the amplitude determined by the absorption characteristic around the absorption central wavelength, it is possible to set lower the bias current value of the modulation signal to be applied and to set smaller the current amplitude of the modulation signal, thereby decreasing the power consumption, and further, by improving the nonlinear state of the intensity characteristic, modulation distortion of the laser light can be lowered, and the precision of measurement of the gas to be measured is substantially improved, and the gas detector having the tunable wavelength semiconductor laser incorporated therein.

## Claims

1. A tunable wavelength semiconductor laser comprising:
an n-type semiconductor substrate;
an active layer which is disposed above the n-type semiconductor substrate and which generates light;
a p-type cladding layer disposed above the active layer; and
wavelength selecting means for causing to selectively oscillate only a specific wavelength from the light generated in the active layer,
the tunable wavelength semiconductor laser capable of oscillating at the specific wavelength being performed by causing current to flow into the active layer, and the specific wavelength being varied by changing the magnitude of the current, wherein
a device length showing a length in a propagation direction of the light generated in the active layer is about 200 µm to 500 µm, and
the p-type cladding layer includes a lightly doped cladding layer having a low impurity concentration and a heavily doped cladding layer having a high impurity concentration which are sequentially arranged from the active layer side.

2. The tunable wavelength semiconductor laser according to claim 1, wherein, when the p-type cladding layer has Zn as a p-type impurity, the impurity concentration of the lightly doped cladding layer is undoped or about 3 × 10¹⁷/cm³, and the impurity concentration of the heavily doped cladding layer is about 1 × 10¹⁸/cm³.

3. The tunable wavelength semiconductor laser according to claim 2, wherein the concentration of the heavily doped cladding layer is desirably 8 × 10¹⁷/cm³ or more at peak, and the concentration of the lightly doped cladding layer is desirably undoped or 4 × 10¹⁷/cm³ or less, with a thickness of about 30 nm to 70 nm.

4. The tunable wavelength semiconductor laser according to claim 1, wherein the p-type cladding layer further includes a moderately doped cladding layer having an intermediate impurity concentration, the moderately doped cladding layer being arranged sequentially to the heavily doped cladding layer.

5. The tunable wavelength semiconductor laser according to claim 4, wherein, when the p-type cladding layer has Zn as a p-type impurity, the impurity concentration of the moderately doped cladding layer is about 5 × 10¹⁷/cm³.

6. The tunable wavelength semiconductor laser according to claim 1, including: a lower separate confinement heterostructure (SCH) layer which is formed above the n-type semiconductor substrate by way of a spacer layer; a multiquantum well (MQW) layer which is formed above the lower SCH layer as the active layer; and an upper SCH layer which is formed above the active layer.

7. The tunable wavelength semiconductor laser according to claim 6, wherein an upper part of the n-type semiconductor substrate, the wavelength selecting means, the lower SCH layer, the active layer, the upper SCH layer and part of the p-type cladding layer are formed in a mesa shape, and
a p-type embedded layer and an n-type embedded layer are formed at both sides of the mesa from the downside.

8. The tunable wavelength semiconductor laser according to claim 1, wherein any one of a distributed feedback type (DFB), a distributed reflection type (DR), a distributed Bragg reflection-type (DBR), a partial diffraction grating type (PC), and an external cavity type (EC) is employed as the structure of the tunable wavelength semiconductor laser.

9. A tunable wavelength semiconductor laser comprising:
an n-type semiconductor substrate;
an active layer which is disposed above the n-type semiconductor substrate and which generates light;
a p-type cladding layer disposed above the active layer; and
wavelength selecting means for causing to selectively oscillate only a specific wavelength from the light generated in the active layer,
the tunable wavelength semiconductor laser capable of oscillating at the specific wavelength being performed by injecting current into the active layer, and the specific wavelength being varied by changing the magnitude of the current, wherein
a width of the active layer orthogonal to a propagation direction of the light generated in the active layer, and showing a length in a direction parallel to the n-type semiconductor substrate is about 1 µm to 2 µm, and
the p-type cladding layer includes a lightly doped cladding layer having a low impurity concentration and a heavily doped cladding layer having a high impurity concentration which are sequentially arranged from the active layer side.

10. The tunable wavelength semiconductor laser according to claim 9, wherein, when the p-type cladding layer has Zn as a p-type impurity, the impurity concentration of the lightly doped cladding layer is undoped or about 3 × 10¹⁷/cm³, and the impurity concentration of the heavily doped cladding layer is about 1 × 10¹⁸/cm³.

11. The tunable wavelength semiconductor laser according to claim 10, wherein the concentration of the heavily doped cladding layer is desirably 8 × 10¹⁷/cm³ or more at peak, and the concentration of the lightly doped cladding layer is desirably undoped or 4 × 10¹⁷/cm³ or less, with a thickness of about 30 nm to 70 nm.

12. The tunable wavelength semiconductor laser according to claim 9, wherein the p-type cladding layer further includes a moderately doped cladding layer having an intermediate impurity concentration, the moderately doped cladding layer being arranged sequentially to the heavily doped cladding layer.

13. The tunable wavelength semiconductor laser according to claim 12, wherein, when the p-type cladding layer has Zn as a p-type impurity, the impurity concentration of the moderately doped cladding layer is about 5 × 10¹⁷/cm³.

14. The tunable wavelength semiconductor laser according to claim 9, including: a lower separate confinement heterostructure (SCH) layer which is formed above the n-type semiconductor substrate by way of a spacer layer; a multiquantum well (MQW) layer which is formed above the lower SCH layer as the active layer; and an upper SCH layer which is formed above the active layer.

15. The tunable wavelength semiconductor laser according to claim 14, wherein an upper part of the n-type semiconductor substrate, the wavelength selecting means, the lower SCH layer, the active layer, the upper SCH layer and part of the p-type cladding layer are formed in a mesa shape, and
a p-type embedded layer and an n-type embedded layer are formed at both sides of the mesa from the downside.

16. The tunable wavelength semiconductor laser according to claim 9, wherein any one of a distributed feedback type (DFB), a distributed reflection type (DR), a distributed Bragg reflection-type (DBR), a partial diffraction grating type (PC), and an external cavity type (EC) is employed as the structure of the tunable wavelength semiconductor laser.

17. A tunable wavelength semiconductor laser comprising:
an n-type semiconductor substrate;
an active layer which is disposed above the n-type semiconductor substrate and which generates light;
a p-type cladding layer disposed above the active layer; and
wavelength selecting means for causing to selectively oscillate only a specific wavelength from the light generated in the active layer,
the tunable wavelength semiconductor laser capable of oscillating at the specific wavelength being performed by injecting current into the active layer, and the specific wavelength being varied by changing the magnitude of the current, wherein
a device length showing a length in a propagation direction of the light generated in the active layer is about 200 µm to 500 µm,
a width of the active layer orthogonal to the propagation direction of the light generated in the active layer, and showing a length in a direction parallel to the substrate is about 1 µm to 2 µm, and
the p-type cladding layer includes a lightly doped cladding layer having a low impurity concentration and a heavily doped cladding layer having a high impurity concentration which are sequentially arranged from the active layer side.

18. The tunable wavelength semiconductor laser according to claim 17, wherein, when the p-type cladding layer has Zn as a p-type impurity, the impurity concentration of the lightly doped cladding layer is undoped or about 3 × 10¹⁷/cm³, and the impurity concentration of the heavily doped cladding layer is about 1 × 10¹⁸/cm³.

19. The tunable wavelength semiconductor laser according to claim 18, wherein the concentration of the heavily doped cladding layer is desirably 8 × 10¹⁷/cm³ or more at peak, and the concentration of the lightly doped cladding layer is desirably undoped or 4 × 10¹⁷/cm³ or less, with a thickness of about 30 nm to 70 nm.

20. The tunable wavelength semiconductor laser according to claim 17, wherein the p-type cladding layer further includes a moderately doped cladding layer having an intermediate impurity concentration, the moderately doped cladding layer being arranged sequentially to the heavily doped cladding layer.

21. The tunable wavelength semiconductor laser according to claim 20, wherein, when the p-type cladding layer has Zn as a p-type impurity, the impurity concentration of the moderately doped cladding layer is about 5 × 10¹⁷/cm³.

22. The tunable wavelength semiconductor laser according to claim 17, including: a lower separate confinement heterostructure (SCH) layer which is formed above the n-type semiconductor substrate by way of a spacer layer; a multiquantum well (MQW) layer which is formed above the lower SCH layer as the active layer; and an upper SCH layer which is formed above the active layer.

23. The tunable wavelength semiconductor laser according to claim 22, wherein an upper part of the n-type semiconductor substrate, the wavelength selecting means, the lower SCH layer, the active layer, the upper SCH layer and part of the p-type cladding layer are formed in a mesa shape, and
a p-type embedded layer and an n-type embedded layer are formed at both sides of the mesa from the downside.

24. The tunable wavelength semiconductor laser according to claim 17, wherein any one of a distributed feedback type (DFB), a distributed reflection type (DR), a distributed Bragg reflection-type (DBR), a partial diffraction grating type (PC), and an external cavity type (EC) is employed as the structure of the tunable wavelength semiconductor laser.

25. A gas detector comprising:
a semiconductor laser module having a tunable wavelength semiconductor laser incorporated therein, the semiconductor laser module emitting laser light modulated in wavelength at a specified frequency;
a photoreceiver which receives laser light to convert into an electrical signal, the laser light being emitted from the semiconductor laser module and having passed through a gas to be measured; and
a gas detection unit which detects the gas to be measured on the basis of the electrical signal output from the photoreceiver,
the tunable wavelength semiconductor laser incorporated in the semiconductor laser module comprising:
an n-type semiconductor substrate;
an active layer which is disposed above the n-type semiconductor substrate and which generates light;
a p-type cladding layer disposed above the active layer; and
wavelength selecting means for causing to selectively oscillate only a specific wavelength from the light generated in the active layer,
the tunable wavelength semiconductor laser capable of oscillating at the specific wavelength being performed by injecting current into the active layer, and the specific wavelength being varied by changing the magnitude of the current, wherein
a device length showing a length in a propagation direction of the light generated in the active layer is about 200 µm to 500 µm, and
the p-type cladding layer includes a lightly doped cladding layer having a low impurity concentration and a heavily doped cladding layer having a high impurity concentration which are sequentially arranged from the active layer side.

26. The gas detector according to claim 25, wherein, when the p-type cladding layer has Zn as a p-type impurity, the impurity concentration of the lightly doped cladding layer is undoped or about 3 x 10¹⁷/cm³, and the impurity concentration of the heavily doped cladding layer is about 1 × 10¹⁸/cm³.

27. The gas detector according to claim 26, wherein the concentration of the heavily doped cladding layer is desirably 8 × 10¹⁷/cm³ or more at peak, and the concentration of the lightly doped cladding layer is desirably undoped or 4 × 10¹⁷/cm³ or less, with a thickness of about 30 nm to 70 nm.

28. The gas detector according to claim 25, wherein the p-type cladding layer further includes a moderately doped cladding layer having an intermediate impurity concentration, the moderately doped cladding layer being arranged sequentially to the heavily doped cladding layer.

29. The gas detector according to claim 28, wherein, when the p-type cladding layer has Zn as a p-type impurity, the impurity concentration of the moderately doped cladding layer is about 5 × 10¹⁷/cm³.

30. The gas detector according to claim 25, including: a lower separate confinement heterostructure (SCH) layer which is formed above the n-type semiconductor substrate by way of a spacer layer; a multiquantum well (MQW) layer which is formed above the lower SCH layer as the active layer; and an upper SCH layer which is formed above the active layer.

31. The gas detector according to claim 30, wherein an upper part of the n-type semiconductor substrate, the wavelength selecting means, the lower SCH layer, the active layer, the upper SCH layer and part of the p-type cladding layer are formed in a mesa shape, and
a p-type embedded layer and an n-type embedded layer are formed at both sides of the mesa shape from the downside.

32. The gas detector according to claim 25, wherein any one of a distributed feedback type (DFB), a distributed reflection type (DR), a distributed Bragg reflection-type (DBR), a partial diffraction grating type (PC), and an external cavity type (EC) is employed as the structure of the tunable wavelength semiconductor laser.

33. A gas detector comprising:
a semiconductor laser module having a tunable wavelength semiconductor laser incorporated therein, the semiconductor laser module emitting laser light modulated in wavelength at a specified frequency;
a photoreceiver which receives laser light to convert into an electrical signal, the laser light being emitted from the semiconductor laser module and having passed through a gas to be measured; and
a gas detection unit which detects the gas to be measured on the basis of the electrical signal output from the photoreceiver,
the tunable wavelength semiconductor laser incorporated in the semiconductor laser module comprising:
an n-type semiconductor substrate;
an active layer which is disposed above the n-type semiconductor substrate and which generates light;
a p-type cladding layer disposed above the active layer; and
wavelength selecting means for causing to selectively oscillate only a specific wavelength from the light generated in the active layer,
the tunable wavelength semiconductor laser capable of oscillating at the specific wavelength being performed by injecting current into the active layer, and the specific wavelength being varied by changing the magnitude of the current, wherein
a width of the active layer orthogonal to a propagation direction of the light generated in the active layer, and showing a length in a direction parallel to the n-type semiconductor substrate is about 1 µm to 2 µm, and
the p-type cladding layer includes a lightly doped cladding layer having a low impurity concentration and a heavily doped cladding layer having a high impurity concentration which are sequentially arranged from the active layer side.

34. The gas detector according to claim 33, wherein, when the p-type cladding layer has Zn as a p-type impurity, the impurity concentration of the lightly doped cladding layer is undoped or about 3 × 10¹⁷/cm³, and the impurity concentration of the heavily doped cladding layer is about 1 × 10¹⁸/cm³.

35. The gas detector according to claim 34, wherein the concentration of the heavily doped cladding layer is desirably than 8 × 10¹⁷/cm³ or more at peak, and the concentration of the lightly doped cladding layer is desirably undoped or 4 × 10¹⁷/cm³ or less, with a thickness of about 30 nm to 70 nm.

36. The gas detector according to claim 33, wherein the p-type cladding layer further includes a moderately doped cladding layer having an intermediate impurity concentration, the moderately doped cladding layer being arranged sequentially to the heavily doped cladding layer.

37. The gas detector according to claim 36, wherein, when the p-type cladding layer has Zn as a p-type impurity, the impurity concentration of the moderately doped cladding layer is about 5 × 10¹⁷/cm³.

38. The gas detector according to claim 34, including: a lower separate confinement heterostructure (SCH) layer which is formed above the n-type semiconductor substrate by way of a spacer layer; a multiquantum well (MQW) layer which is formed above the lower SCH layer as the active layer; and an upper SCH layer which is formed above the active layer.

39. The gas detector according to claim 38, wherein an upper part of the n-type semiconductor substrate, the wavelength selecting means, the lower SCH layer, the active layer, the upper SCH layer and part of the p-type cladding layer are formed in a mesa shape, and
a p-type embedded layer and an n-type embedded layer are formed at both sides of the mesa from the downside.

40. The gas detector according to claim 33, wherein any one of a distributed feedback type (DFB), a distributed reflection type (DR), a distributed Bragg reflection-type (DBR), a partial diffraction grating type (PC), and an external cavity type (EC) is employed as the structure of the tunable wavelength semiconductor laser.

41. A gas detector comprising:
a semiconductor laser module having a tunable wavelength semiconductor laser incorporated therein, the semiconductor laser module emitting laser light modulated in wavelength at a specified frequency;
a photoreceiver which receives laser light to convert into an electrical signal, the laser light being emitted from the semiconductor laser module and having passed through a gas to be measured; and
a gas detection unit which detects the gas to be measured on the basis of the electrical signal output from the photoreceiver,
the tunable wavelength semiconductor laser incorporated in the semiconductor laser module comprising:
an n-type semiconductor substrate;
an active layer which is disposed above the n-type semiconductor substrate and which generates light;
a p-type cladding layer disposed above the active layer; and
wavelength selecting means for causing to selectively oscillate only a specific wavelength from the light generated in the active layer,
the tunable wavelength semiconductor laser capable of oscillating at the specific wavelength being performed by injecting current into the active layer, and the specific wavelength being varied by changing the magnitude of the current, wherein
a device length showing a length in a propagation direction of the light generated in the active layer is about 200 µm to 500 µm,
a width of the active layer orthogonal to the propagation direction of the light generated in the active layer, and showing a length in a direction parallel to the substrate is about 1 µm to 2 µm, and
the p-type cladding layer includes a lightly doped cladding layer having a low impurity concentration and a heavily doped cladding layer having a high impurity concentration which are sequentially arranged from the active layer side.

42. The gas detector according to claim 41, wherein, when the p-type cladding layer has Zn as a p-type impurity, the impurity concentration of the lightly doped cladding layer is undoped or about 3 x 10¹⁷/cm³, and the impurity concentration of the heavily doped cladding layer is about 1 × 10¹⁸/cm³.

43. The gas detector according to claim 42, wherein the concentration of the heavily doped cladding layer is desirably 8 × 10¹⁷/cm³ or more at peak, and the concentration of the lightly doped cladding layer is desirably undoped or 4 × 10¹⁷/cm³ or less, with a thickness of about 30 nm to 70 nm.

44. The gas detector according to claim 41, wherein the p-type cladding layer further includes a moderately doped cladding layer having an intermediate impurity concentration, the moderately doped cladding layer being arranged sequentially to the heavily doped' cladding layer.

45. The gas detector according to claim 44, wherein, when the p-type cladding layer has Zn as a p-type impurity, the impurity concentration of the moderately doped cladding layer is about 5 x 10¹⁷/cm³.

46. The gas detector according to claim 41, including: a lower separate confinement heterostructure (SCH) layer which is formed above the n-type semiconductor substrate by way of a spacer layer; a multiquantum well (MQW) layer which is formed above the lower SCH layer as the active layer; and an upper SCH layer which is formed above the active layer.

47. The gas detector according to claim 46, wherein an upper part of the n-type semiconductor substrate, the wavelength selecting means, the lower SCH layer, the active layer, the upper SCH layer and part of the p-type cladding layer are formed in a mesa shape, and
a p-type embedded layer and an n-type embedded layer are formed at both sides of the mesa from the downside.

48. The gas detector according to claim 41, wherein any one of a distributed feedback type (DFB), a distributed reflection type (DR), a distributed Bragg reflection-type (DBR), a partial diffraction grating type (PC), and an external cavity type (EC) is employed as the structure of the tunable wavelength semiconductor laser.
